# EUROPÄISCHE PATENTSCHRIFT

(11) **EP 2 908 298 B1**
(45) Veröffentlichungstag und Bekanntmachung des Hinweises auf die Patenterteilung: **18.04.2018**
(21) Anmeldenummer: 14155048.3
(22) Anmeldetag: 13.02.2014
(51) Int. Cl.: G08B 17/107, G08B 17/113

(54) **Rauchmelder nach dem Streulichtprinzip mit einer zweifarbigen Leuchtdiode mit unterschiedlich grossen LED-Chips**
Smoke detector based on the scattered light principle with a two-colour light emitting diode with differently sized LED chips
Détecteur de fumée fonctionnant selon le principe de la lumière diffusée comprenant une diode lumineuse bicolore dotée de puces LED de différentes tailles

(43) Veröffentlichungstag der Anmeldung: 19.08.2015
(73) Patentinhaber: Siemens Schweiz AG, 8047 Zürich (CH)
(72) Erfinder: Aebersold, Hans, 8906 Bonstetten (CH)
(74) Vertreter: Maier, Daniel Oliver

(56) Entgegenhaltungen:
- EP-A2- 0 877 345
- WO-A1-2008/086890
- US-A1- 2004 000 867
- US-A1- 2009 080 185

## Beschreibung

Die Erfindung betrifft einen optischen Rauchmelder mit einer nach dem Streulichtprinzip arbeitenden Detektionseinheit.

Derartige Rauchmelder werden auch als Brandmelder bezeichnet. Sie weisen typischerweise ein Gehäuse mit zumindest einer Raucheintrittsöffnung sowie die im Gehäuse aufgenommene Detektionseinheit für die Rauchdetektion auf. Die Detektionseinheit umfasst vorzugsweise eine gegen Umgebungslicht abgeschirmte, jedoch für zu detektierenden Rauch durchlässige optische Messkammer. Letztere weist typischerweise auch eine Vielzahl von Umgebungslicht abschirmenden Lamellen auf und wird daher auch als Labyrinth bezeichnet.

Die betrachtete Detektionseinheit umfasst eine Leuchtdiode zum Bestrahlen von zu detektierenden Partikeln sowie einen dafür spektral empfindlichen Photosensor zur Detektion des von den Partikeln gestreuten Lichts. Mit der Leuchtdiode und dem Photosensor ist typischerweise auch eine elektronische Steuereinheit als Teil des Rauchmelders verbunden. Die Steuereinheit ist dazu eingerichtet, eine Warnmeldung und/oder eine Alarmmeldung auszugeben, falls ein jeweiliger Mindestkonzentrationswert von Rauch detektierbar ist.

Aus der EP 0 877 345 A2 ist ein Streulichtrauchmelder bekannt, der eine Lichtemissionseinrichtung zum Emittieren von Licht zweier verschiedener Wellenlängen, eine Lichtempfangseinrichtung zum Empfangen gestreuten Lichts der zwei verschiedenen Wellenlängen, eine Recheneinrichtung zum Durchführen einer zur Rauchdetektion benötigten Berechnung aus einer Streulichtausgabe der ersten Wellenlänge und einer Streulichtausgabe der zweiten Wellenlänge der Lichtempfangseinrichtung sowie eine Rauchdetektionsverarbeitungseinrichtung zum Durchführen eines Rauchdetektionsprozesses auf Grundlage einer Rechenergebnisausgabe der Recheneinrichtung aufweist. Gemäss einer dortigen Ausführung gemäss Figur 13 ist die Verwendung eines Lichtemissionsgeräts, das heisst einer Zweifarben-Leuchtdiode bekannt, in dem eine erste und zweite Lichtemissionseinrichtung an Positionen angeordnet sind, die sehr nahe beieinander liegen und das Licht der ersten und zweiten Wellenlänge in gleicher Lichtemissionsrichtung emittieren.

Aus dem Stand der Technik sind weiterhin Detektionseinheiten bekannt, die zwei unterschiedlich farbige Leuchtdioden sowie einen Photosensor in einer oder in zwei Streulichtanordnungen einsetzen. Zur Aussendung des roten oder infraroten Lichts ist der Einsatz einer rotleuchtenden LED oder einer Infrarot-LED, zur Aussendung von blauem oder violettem Licht der Einsatz einer blau- bzw. violettleuchtenden LED bekannt. Durch geeignete Auswertung des vom Photosensor empfangenen jeweiligen farbigen Streulichts ist dann eine Auswertung hinsichtlich der Partikelgrösse der detektierten Rauchpartikel möglich. Mittels geeigneter Bewertung der ermittelten Partikelgrössen ist z.B. eine Unterscheidung von Rauch, Staub und Wasserdampf möglich. Die Ausgabe eines möglichen Fehlalarms kann dadurch vermieden werden.

Die bekannten Rauchmelder sind typischerweise zum Betrieb an einer Melderlinie mit einer Vielzahl weiterer daran angeschlossener Rauchmelder oder zum batteriegestützten Stand-Alone-Betrieb eingerichtet. Dies bedingt für beide Fälle, dass nur eine sehr geringe mittlere elektrische Leistung von weniger als 10 mW zur Verfügung steht. Die Ansteuerung der Leuchtdioden zum Aussenden des jeweiligen Lichts erfolgt daher typischerweise gepulst. Ebenso ist die gesamte "Elektronik" für einen möglichst geringen Leistungsbedarf ausgelegt.

Ausgehend von dem eingangs genannten Stand der Technik ist es eine Aufgabe der Erfindung, einen Rauchmelder mit einer verbesserten Detektionseinheit anzugeben.

Die Aufgabe wird mit den Gegenständen des Hauptanspruchs gelöst. Vorteilhafte Ausführungsformen der vorliegenden Erfindung sind in den abhängigen Ansprüchen angegeben.

Erfindungsgemäss weist die Leuchtdiode einen ersten als Flächenstrahler ausgebildeten LED-Chip zum Aussenden eines ersten Lichtbündels mit Licht in einem ersten Wellenlängenbereich von 350 nm bis 500 nm auf. Sie weist ausserdem einen zweiten als Flächenstrahler ausgebildeten LED-Chip zum Aussenden eines zweiten Lichtbündels mit Licht in einem zweiten Wellenlängenbereich von 665 nm bis 1000 nm auf. Das von den LED-Chips ausgesandte jeweilige Licht ist dabei hauptsächlich monochromatisches Licht.

Mit "Flächenstrahler" ist hier gemeint, dass das Licht aus einer ebenen Fläche mit einer Lambert'schen Lichtverteilung abgestrahlt wird. Die Flächenstrahler können somit auch als Lambert-Strahler bezeichnet werden.

Beide LED-Chips sind nebeneinander angeordnet.

Alternativ können beide LED-Chips zumindest teilweise überlappend angeordnet sein. Es kann auch der im Vergleich zum zweiten LED-Chip deutlich kleinere erste LED-Chip auf dem zweiten LED-Chip, insbesondere mittig bzw. zentrisch zu diesem, angeordnet sein.

Die LED-Chips stammen üblicherweise aus einem Wafer mit einer Vielzahl in einem optoelektronischen Halbleiterprozess hergestellter LED-Chips. Ein solcher Wafer wird durch mechanische Trennprozesse, insbesondere durch Sägen oder Brechen, in die Vielzahl der LED-Chips zerlegt. Ein solches "nacktes" und für sich vollständig funktionsfähiges Bauteil wird auch als "Die" bezeichnet. Es weist daher eine typischerweise quadratische oder rechteckige Form auf.

Weiterhin liegt gemäss der Erfindung das Verhältnis der optisch aktiven Oberfläche des ersten LED-Chips zu der optisch aktiven Oberfläche des zweiten LED-Chips in einem Bereich von 2 bis 20. Der erste LED-Chip emittiert somit Licht im blaugrünen, blauen, violetten oder ultravioletten Bereich, der zweite LED-Chip dagegen Licht im rot/orangen, roten oder infrarotem Bereich.

Nach einer vorteilhaften Ausführungsform liegt das Verhältnis der optisch aktiven Oberfläche des ersten LED-Chips zu der optisch aktiven Oberfläche des zweiten LED-Chips in einem Bereich von 2,5 bis 6,5.

Mit "optisch aktiv" sind die Teile der Oberfläche der LED-Chips gemeint, die bei Stromerregung Licht emittieren. Bereiche für die Kontaktierung der LED-Chips auf der Oberfläche, die z.B. zur Kontaktierung eines Bonddrahts bestimmt sind, gehören somit nicht dazu.

Der Kern der Erfindung liegt zum einen in der Integration von zwei einzelfarbigen Leuchtdioden zu einer einzigen (nur) zweifarbigen Leuchtdiode.

Dadurch reduziert sich vorteilhaft die Bauteilanzahl. Ein weiterer Vorteil liegt darin, dass auf eine aufwändige Kalibrierung des optischen Pfads nach der Montage der zweifarbigen Leuchtdiode verzichtet werden kann. Üblicherweise erfordern die bei der Montage von zwei Leuchtdioden auftretenden relativen Abweichungen in Ausrichtung und Platzierung zueinander eine aufwändige Kalibrierung.

Zum anderen liegt der Erfindung die Erkenntnis zugrunde, dass hinsichtlich des elektrischen Leistungsbedarfs für die optische Rauchdetektion vor allem der "blaue" Anteil der massgebliche Anteil ist. Grund hierfür ist der erheblich schlechtere Wirkungsgrad bei der Erzeugung von blauem Licht im Vergleich zu rotem bzw. infrarotem LED-Licht. Typischerweise ist die Erzeugung von blauem bzw. violettem Licht in etwa um den Faktor 10 schlechter als die Erzeugung von roten bzw. infrarotem Licht. So ist für die Erzeugung von blauem Licht mit einer Wellenlänge von 470 nm (LED-Typ SFH4570 von OSRAM) circa die 11-fache optisch aktive Oberfläche für eine gleiche Bestrahlungsstärke erforderlich wie für die Erzeugung von infrarotem Licht mit einer Wellenlänge von 940 nm (LED-Typ SFH4550 von OSRAM).

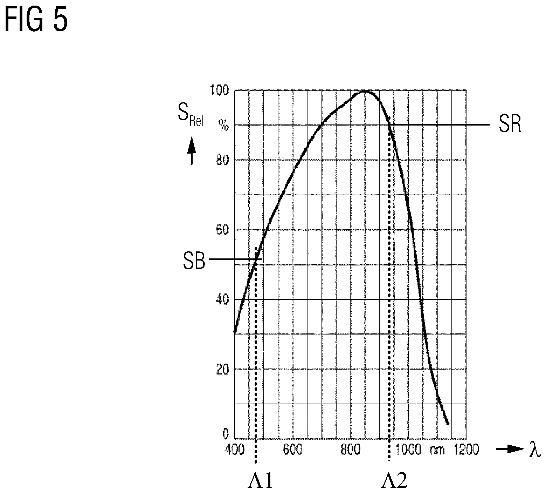

Hinzu kommt noch die deutlich schlechtere spektrale Empfindlichkeit von blauem Licht bei Silizium-PIN-Photodioden, die üblicherweise als Photosensoren eingesetzt werden. So ist unter Annahme der zuvor beschriebenen beispielhaften OSRAM-LEDs die Detektion des blauen Lichts um den Faktor 1.7 schlechter als die Detektion des infraroten Lichts (siehe dazu FIG 5). Für die gesamte elektrisch-optisch-elektrische Wirkungsgradkette resultiert in Summe sogar ein Faktor von ca. 19 = 11 x 1.7.

Erfindungsgemäss wird nun die optisch aktive Oberfläche des blauleuchtenden LED-Chips so bemessen, dass ein qualitativ ausreichendes Photosensorsignal für eine zuverlässige Rauchdetektion gewährleistet ist. Dagegen kann wegen des erheblich besseren elektrisch-optisch-elektrischen Wirkungsgrades des "roten" Anteils die Oberfläche des "roten" LED-Chips für die Erzeugung des roten bzw. infraroten Lichts auf einen Bruchteil reduziert werden. Dadurch reduzieren sich vorteilhaft der elektrische Leistungsbedarf sowie die Kosten für eine derartige zweifarbige LED.

Nach einer Ausführungsform ist der erste LED-Chip zum Aussenden von Licht mit einer Wellenlänge von 460 nm ± 40 nm oder 390 nm ± 40 nm, und der zweite LED-Chip zum Aussenden von Licht mit einer Wellenlänge von 940 nm ± 40 nm oder 860 nm ± 40 nm ausgebildet.

Vorzugsweise weist die Leuchtdiode eine Symmetrieachse auf. Die jeweilige Hauptabstrahlrichtung der beiden LED-Chips ist parallel zur Symmetrieachse. Die Symmetrieachse kann auch als konstruktive Hauptachse oder Längsachse bezeichnet werden. Im Fall von gängigen 5 mm- oder 3 mm-Leuchtdioden, die "off the shelf", also als massenhaftes Consumerprodukt verkauft werden, ist dies die Rotationssymmetrieachse bezogen auf das Kunststoffgehäuse derartiger Leuchtdioden.

Beide LED-Chips sind auf einer Trägerplatte der Leuchtdiode appliziert und mit aus dem Kunststoffgehäuse herausgeführten elektrischen Anschlüssen verbunden. Die Flächennormale der Trägerplatte verläuft in diesem Fall parallel zur Symmetrieachse der Leuchtdiode.

Alternativ dazu ist zumindest eine der Hauptabstrahlrichtungen zur Symmetrieachse geneigt. Dadurch ist eine Fokussierung und/oder optische Lenkung des jeweiligen erzeugten Lichtbündels möglich.

Nach einer Ausführungsform ist in der Detektionseinheit eine Blendeneinrichtung mit einer Blendenöffnung zwischen der Leuchtdiode und dem Photosensor angeordnet. Die gebildete Blendenöffnung ist typischerweise rechteckig, kann aber auch rund sein. Die Blendeneinrichtung ist derart angeordnet und ausgerichtet, dass die von den beiden LED-Chips ausgesandten Lichtbündel im Wesentlichen vollständig durch die Blendenöffnung hindurchtreten.

Mit "im Wesentlichen vollständig" ist hier gemeint, dass mehr als 95% des gesamten vom jeweiligen LED-Chips ausgesandten Lichts durch die Blendenöffnung hindurchtritt. Technischer Hintergrund ist, dass ausserhalb der idealisiert eingezeichneten Lichtbündel bzw. Lichtbündelgrenzen durchaus noch ein bei der Lichterzeugung und Lichtauskopplung nicht ganz zu vermeidendes Restlicht bzw. Streulicht vorhanden ist. Dieses Restlicht wird nun zur Vermeidung von direktem LED-Licht auf den Photosensor wirksam abgeschirmt.

Nach einer gegenüber der vorherigen Ausführungsform alternativen Ausführungsform ist die Blendeneinrichtung derart angeordnet und ausgerichtet, dass weniger als 75% des vom ersten LED-Chip ausgesandten ersten Lichtbündels und weniger als 75% des vom zweiten LED-Chip ausgesandten zweiten Lichtbündels durch die Blendenöffnung hindurchtreten. Dadurch ist gewährleistet, dass montagebedingte Einbautoleranzen der Leuchtdiode gegenüber der Blende sich nur geringfügig auf die Rauchdetektion auswirken. Insbesondere beleuchtet der Teil des ersten Lichtbündels, der nicht durch die Blendenöffnung hindurchtritt, einen ersten an die Blendenöffnung angrenzenden Teil der Blendeneinrichtung, während der Teil des zweiten Lichtbündels, der nicht durch die Blendenöffnung hindurchtritt, einen zweiten an die Blendenöffnung angrenzenden Teil der Blendeneinrichtung beleuchtet.

Dadurch dass beide Lichtbündel eine gewisse Beleuchtungsreserve aufweisen, indem das jeweilige Lichtbündel auch einen Teil der Blendeneinrichtung beleuchtet, ist trotz Verkippung (Tilt) oder Verdrehung der Leuchtdiode eine weitgehend homogene Beleuchtung des Streuzentrums möglich. Eine derartige Detektionseinheit ist daher gegen Stoss und Vibration mechanisch und funktional robuster.

Einer gegenüber den beiden vorherigen Ausführungsform vorteilhaften alternativen Ausführungsform zufolge ist die Blendeneinrichtung derart angeordnet und ausgerichtet, dass das von einem der LED-Chips ausgesandte Lichtbündel im Wesentlichen vollständig durch die Blendenöffnung hindurchtritt, während weniger als 75% des vom anderen LED-Chip ausgesandten Lichtbündels durch die Blendenöffnung hindurchtritt. Dadurch ist gewährleistet, dass montagebedingte Einbautoleranzen der Leuchtdiode gegenüber der Blende sich nur geringfügig auf die Rauchdetektion auswirken.

Nach einer weiteren Ausführungsform ist die Leuchtdiode derart um die Symmetrieachse gedreht angeordnet, dass das vom zweiten LED-Chip ausgesandte Licht im Vergleich zum ausgesandten Licht des ersten LED-Chips mehr zum Photosensor hin gerichtet ist. Dadurch wird vorteilhaft der hinsichtlich der Wirkungsgradkette schwächere "Blau"-Anteil bevorzugt.

Für den kombinierten Fall, dass das vom ersten LED-Chip ausgesandte "blaue" Lichtbündel im Wesentlichen vollständig durch die Blendenöffnung hindurchtritt, während das vom zweiten LED-Chip ausgesandte "rote" Lichtbündel nur teilweise durch die Blendenöffnung hindurchtritt, ist vorteilhaft eine Bevorzugung des sonst schwächeren Blauanteils möglich. Dies indem ein Teil des "roten" Lichtbündels einen Teil der Blendeneinrichtung beleuchtet anstatt das Streulichtzentrum durch die Blendenöffnung hindurch zu beleuchten.

Einer weiteren Ausführungsform zufolge weist die Leuchtdiode ein Gehäuse aus einem vorzugsweise transparenten Kunststoff auf. Mit "transparent" ist hier gemeint, dass das Kunststoffgehäuse für das vom ersten und zweiten LED-Chip stammende emittierte Licht durchlässig ist. Das Gehäuse bildet entlang des Bereichs nach dem Lichtaustritt aus den beiden LED-Chips eine optische Linse aus. Alternativ oder zusätzlich ist zwischen der Leuchtdiode und der Blendenöffnung eine optische Linseneinheit angeordnet. Dadurch ist eine Lichtbündelung und/oder Lichtlenkung des von den beiden LED-Chips ausgesandten Lichts in Richtung zum vorgesehenen Streulichtbereich in der Detektionseinheit möglich.

Nach einer vorteilhaften Ausführungsform weist die Leuchtdiode eine senkrecht zur Symmetrieachse und durch die beiden nebeneinander angeordneten LED-Chips verlaufende Querachse auf. Es ist eine durch die Symmetrie- und Querachse verlaufende Lichtebene festgelegt. Es ist durch die optische Linse oder durch die optische Linseneinheit ein auf der Symmetrieachse liegenden Fokuspunkt optisch festgelegt. Weiterhin ist mit dem Fokuspunkt als Scheitelpunkt ein Blendenwinkel definiert, der sich ausgehend von der Symmetrieachse innerhalb der Lichtebene erstreckt. Es ist ein erster und zweiter Abblendwinkelwert für den Abstrahlwinkel durch zwei sich gegenüberliegende, die Blendenöffnung begrenzende Innenränder der Blendeneinrichtung bestimmt. Die Blendeneinrichtung ist derart ausgerichtet und bemessen, dass die beiden Abblendwinkelwerte unterschiedlich gross sind.

Nach einer Ausführungsform ist die Blendeneinrichtung derart ausgerichtet und bemessen, dass die beiden Abblendwinkelwerte sich betragsmässig um den Faktor zwei bis sechs unterscheiden.

Durch die asymmetrische Gewichtung der beiden Abblendwinkel im Bezug auf die Symmetrieachse ist eine bevorzugte volumenmässige grössere Bestrahlung des Streulichtzentrum mit Licht von einem der beiden LED-Chips in der Detektionseinheit möglich.

Insbesondere ist dies vorteilhaft für den Fall, dass das vom zweiten LED-Chip ausgesandte "rote" Licht im Vergleich zum ausgesandten Licht des ersten LED-Chips mehr zum Photosensor hin gerichtet ist. Dadurch wird der hinsichtlich der Wirkungsgradkette schwächere "Blau"-Anteil deutlich bevorzugt.

Nach einer Ausführungsform weist der Rauchmelder eine mit der Leuchtdiode und mit dem Photosensor verbundene elektronische Steuereinheit auf. Die Steuereinheit ist dazu eingerichtet, eine Warnmeldung und/oder eine Alarmmeldung auszugeben, falls ein jeweiliger Mindestkonzentrationswert von Rauch detektierbar ist.

Die Steuereinheit ist vorzugsweise ein Mikrocontroller. Sie ist dazu eingerichtet, die beiden LED-Chips zum Aussenden des jeweiligen Lichts elektrisch anzusteuern und dazu synchronisiert das jeweilige elektrische Signal vom Photosensor zu erfassen und auszuwerten. Durch Differenzbildung oder Verhältnisbildung aus den beiden jeweiligen, der "Farbe" zugeordneten empfangenen Signalamplituden des Photosensors ist eine Bestimmung der Partikelgrösse möglich. Durch entsprechenden Vergleich vorzugsweise des "blauen" Signals mit einem jeweiligen Mindestkonzentrationswert ist dann eine Warnmeldung und/oder eine Alarmmeldung ausgebbar. Die jeweiligen Verarbeitungsschritte für die zeitliche Ansteuerung der beiden LED-Chips sowie die synchronisierte Erfassung und Auswertung des jeweiligen Photosensorsignals können durch geeignete, auf dem Mikrocontroller ausführbare Programmschritte realisiert sein.

Einer vorteilhaften Ausführungsform zufolge ist die Steuereinheit dazu eingerichtet, den ersten LED-Chip mit seinem spezifizierten Nennstrom anzusteuern. Die Steuereinheit ist weiterhin dazu eingerichtet, den zweiten LED-Chip mit einem im Vergleich zu seinem spezifizierten Nennstrom festlegbaren Reduktionsfaktor anzusteuern.

Mit "spezifizierten Nennstrom" ist hier der vom Leuchtdiodenhersteller typischerweise in einem Datenblatt spezifizierte Nennstromwert gemeint. Dadurch ist vorteilhaft eine Reduktion der für den Betrieb des zweiten LED-Chips erforderlichen elektrischen Leistung möglich. Grund hierfür ist eine fertigungs- und montagetechnisch bedingte Mindestchipgrösse für den zweiten LED-Chip, das heisst für den rotleuchtenden LED-Chip. Durch den Reduktionsfaktor, der typischerweise im Bereich zwischen 2 bis 4 liegt, wird sozusagen eine "elektronische Verkleinerung" der Chipfläche des zweiten LED-Chips bewirkt. Darüber hinaus ist über diesen Reduktionsfaktor auch eine Kalibrierung der Ansteuerung für den ersten und zweiten LED-Chip vorteilhaft möglich.

Vorzugsweise ist der Reduktionsfaktor durch die unterschiedliche spektrale Empfindlichkeit des Photosensors für zu detektierendes gestreutes Licht im ersten und zweiten Wellenlängenbereich festgelegt.

Der Photosensor kann nach einer weiteren Ausführungsform eine Silizium-PIN-Photodiode sein.

Der Photosensor ist vorzugsweise eine Silizium-PIN-Photodiode mit verbesserter Blauempfindlichkeit.

Schliesslich sind durch die elektronische Steuereinheit beide LED-Chips abwechselnd gepulst oder gleichzeitig gepulst ansteuerbar. Im ersten Fall ist lediglich ein Photosensor erforderlich. Im zweiten Fall können zwei Photosensoren für das jeweilige zu detektierende Streulicht erforderlich sein.

Die Erfindung sowie vorteilhafte Ausführungen der vorliegenden Erfindung werden am Beispiel der nachfolgenden Figuren erläutert. Dabei zeigen:
- FIG 1: eine beispielhafte nach dem Streulichtprinzip arbeitende Detektionseinheit für einen Rauchmelder mit einer Leuchtdiode und mit einem Photoempfänger gemäss der Erfindung,
- FIG 2: eine Aufsicht auf die beispielhafte Leuchtdiode aus FIG 1 mit zwei integrierten und unterschiedlich grossen LED-Chips zum Aussenden von zweifarbigem Licht,
- FIG 3: zeigt die Leuchtdiode aus FIG 1 mit einer vorgeschalteten alternativen Blendeneinrichtung,
- FIG 4: zeigt die Leuchtdiode aus FIG 1 mit einer vorgeschalteten weiteren alternativen Blendeneinrichtung und
- FIG 5: ein Beispiel für die spezifische spektrale Empfindlichkeit einer Silizium-PIN-Photodiode mit erhöhter Blauempfindlichkeit.

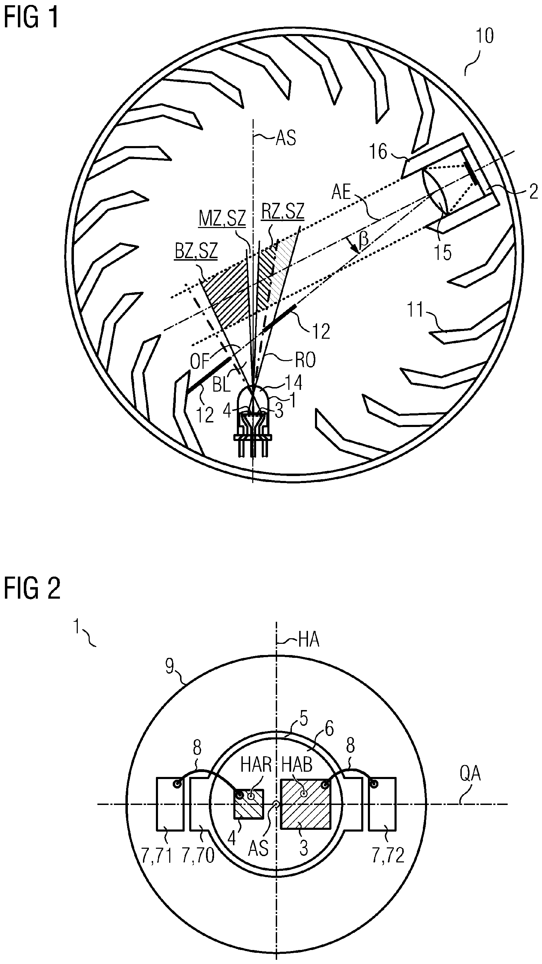

FIG 1 zeigt eine beispielhafte, nach dem Streulichtprinzip arbeitende Detektionseinheit 10 für einen Rauchmelder mit einer Leuchtdiode 1 und mit einem Photoempfänger 2 gemäss der Erfindung. Das die Detektionseinheit 10 umgebende Gehäuse des Rauchmelders ist aus Gründen der Übersichtlichkeit selbst nicht dargestellt. Die Detektionseinheit 10 weist eine optische Messkammer mit einer Vielzahl von Umgebungslicht abschirmenden Lamellen 11 auf. Auf die zeichnerische Abbildung von Raucheintrittsöffnungen im Gehäuse sowie in der Detektionseinheit wurde gleichfalls verzichtet.

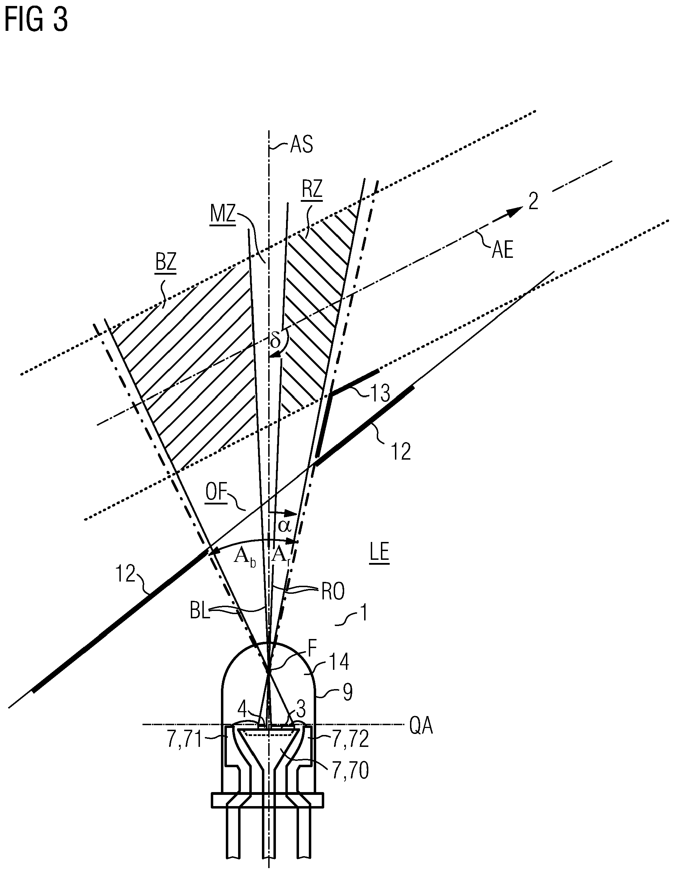

Im Inneren der Detektionseinheit 10 sind gemäss der Erfindung eine (zweifarbige) Leuchtdiode 1 mit zwei LED-Chips 3, 4 sowie ein Photosensor 2 in einer Streulichtanordnung unter einem beispielhaften Winkel von 120° angeordnet (siehe dazu Streulichtwinkel δ im Beispiel der FIG 3). Im vorliegenden Beispiel sind die Leuchtdiode 1 und der Photosensor 2 unter einem Vorwärtsstreulichtwinkel angeordnet. Beide Bauelemente 1, 2 können alternativ auch unter einem Rückwärtsstreuwinkel für Winkelwerte unter 90° angeordnet sein, wie z.B. unter einem Streulichtwinkel δ von 60°.

Beide Bauelemente sind typischerweise elektrisch mit einer Leiterplatte verbunden, die sich üblicherweise ausserhalb der Detektionseinheit 10 befindet und an diese angrenzt. Auf der Leiterplatte können weitere Bauelemente angeordnet sein wie z.B. ein Mikrocontroller, aktive oder passive Bauelemente.

Im Beispiel der FIG 1 ist für die Leuchtdiode 1 eine Symmetrieachse AS sowie für den Photosensor 2 eine optische Empfängerachse AE eingetragen. Deren Winkel zueinander entspricht dabei dem zuvor beschriebenen Streulichtwinkel δ. Desweiteren ist der Leuchtdiode 1 zur Vermeidung von direktem LED-Licht auf den Photosensor 2 eine Blendeneinrichtung 12 in Form einer Lochblende vorgeschaltet. Die Lochblende 12 bildet - wenn auch im vorliegenden Beispiel nicht direkt erkennbar - eine rechteckige oder quadratische Blendenöffnung OF aus. Letztere ist durch zwei nicht weiter gezeigte, parallel zur Bildebene der FIG 1 verlaufende angrenzende Wände der Detektionseinheit 10 sowie durch die in Normalenrichtung zur Bildebene der FIG 1 verlaufenden Innenränder der Lochblende 12 gebildet.

Die Leuchtdiode 1 weist ein Kunststoffgehäuse auf, welches eine optische Linse 14 zur Lichtbündelung des von der Leuchtdiode 1 erzeugten Lichts in Richtung zur Blendenöffnung OF ausbildet. Die gezeigte Leuchtdiode 1 entspricht in ihrem äusseren Erscheinungsbild dem einer typischen 5 mm-Leuchtdiode für eine "Through-Hole-Montage" mit einem Durchmesser des Kunststoffgehäuses von 5 mm. Alternativ kann diese eine 3 mm-Leuchtdiode sein. Sie kann weiterhin alternativ für die Oberflächenmontage ausgeführt sein, d.h. als SMD-Leuchtdiode.

Der gezeigte Photosensor 2 ist ferner von einer Empfängerabblendeinrichtung 16 umgeben. Dem Photosensor 2 ist zudem eine Empfängerlinse 15 zur Fokussierung von Streulicht von zu detektierenden Rauchpartikeln vorgeschaltet. Weiterhin sind die beiden, nicht weiter bezeichneten Wände der Blendeneinrichtung 12 hin zur geometrischen Mitte dieser Empfängerlinse 15 unter einem Abschirmwinkel β ausgerichtet.

Ausgehend von der optischen Abbildungsanordnung aus Leuchtdiode 1 und gegenüberliegender Blendeneinrichtung 12 einerseits und von der optischen Abbildungsanordnung aus Photosensor 2, umgebender Empfängerabblendeinrichtung 16 und vorgeschalteter Empfängerlinse 15 andererseits, ist geometrisch ein Streulichtzentrum SZ mit einem festgelegten Streulichtvolumen bestimmt. Nur Streulicht von zu detektierenden Partikeln in diesem Bereich SZ gelangt schliesslich zu dem Photosensor 2.

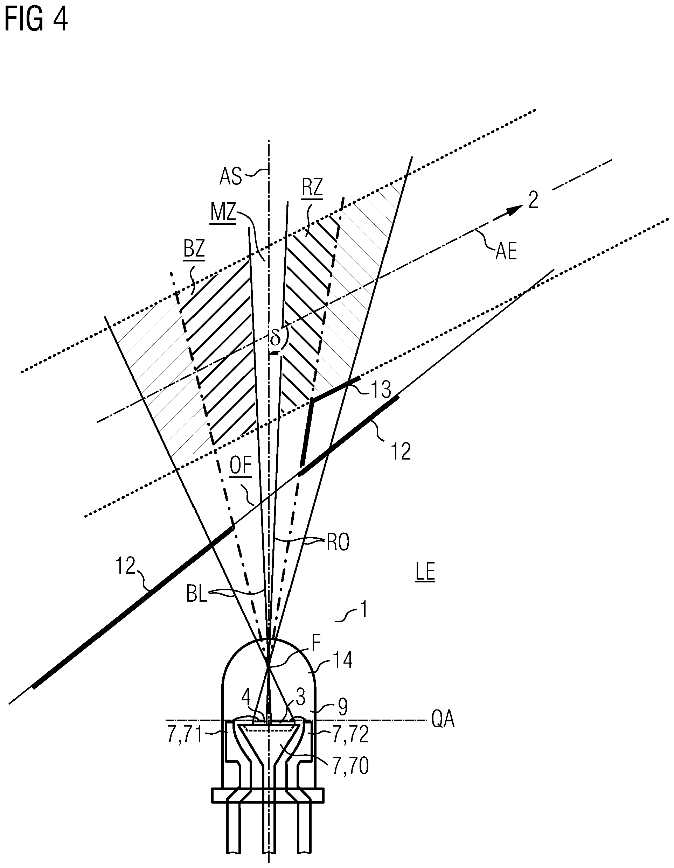

Im vorliegenden Beispiel weist die Leuchtdiode 1 erfindungsgemäss einen ersten als Flächenstrahler ausgebildeten LED-Chip 3 zum Aussenden eines ersten Lichtbündels BL mit Licht in einem ersten Wellenlängenbereich von 350 nm bis 500 nm, d.h. von blaugrünem, blauem, violettem und ultraviolettem Licht, auf. Die Leuchtdiode 1 weist weiterhin einen zweiten als Flächenstrahler ausgebildeten LED-Chip 4 zum Aussenden eines zweiten Lichtbündels RO mit Licht in einem zweiten Wellenlängenbereich von 665 nm bis 1000 nm, d.h. von rot/orangenem, rotem und infrarotem Licht, auf. Beide LED-Chips 3, 4 sind nebeneinander angeordnet. Das Verhältnis der optisch aktiven Oberfläche des ersten LED-Chips 3 zu der optisch aktiven Oberfläche des zweiten LED-Chips 4 liegt weiter erfindungsgemäss in einem Bereich von 2 bis 20, insbesondere in einem Bereich von 2,5 bis 6,5 (siehe dazu auch FIG 4).

Durch die Nebeneinanderanordnung der beiden LED-Chips 3, 4 und durch die nachgeschaltete optische Linse 14 als Teil des LED-Gehäuses senden die beiden LED-Chips 3, 4 bei Stromerregung zwei Lichtbündel BL, RO aus, welche der Einfachheit halber als blaues Lichtbündel BL und als rotes Lichtbündel RO bezeichnet werden. Beide Lichtbündel BL, RO sind nicht, wie vereinfacht dargestellt, scharf gegeneinander abgegrenzt. Die Ränder der beiden Lichtbündel BL, RO sollen lediglich einen Sektorbereich kennzeichnen, innerhalb dessen der grösste Teil der jeweiligen Lichtmenge abgestrahlt wird, wie z.B. 95 %. Daher ist auch ein Überlappungsbereich vorhanden, in dem sich das Restlicht des ausgesandten Lichts mit vergleichsweise geringer Lichtintensität vermischt.

In diesem Sinne setzt sich folglich das in der FIG 1 gezeigte Streulichtzentrum SZ aus einem "blauen" Streulichtzentrum BZ, einem "roten" Streulichtzentrum RZ sowie aus einem gemeinsamen mittleren Streulichtzentrum MZ dazwischen zusammen.

Im vorliegenden Beispiel ist die Blendeneinrichtung 12 gemäss einer Ausführungsform derart angeordnet und ausgerichtet, dass das vom ersten LED-Chip 3 ausgesandte blaue Lichtbündel BL im Wesentlichen vollständig durch die Blendenöffnung OF hindurchtritt. Dagegen tritt das vom zweiten LED-Chip 4 ausgesandte rote Lichtbündel RO nur teilweise, im vorliegenden Beispiel nur zur Hälfte durch die Blendenöffnung OF hindurch.

FIG 2 zeigt eine Aufsicht auf die beispielhafte Leuchtdiode 1 aus FIG 1 mit zwei integrierten und unterschiedlich grossen LED-Chips 3, 4 zum Aussenden von (nur) zweifarbigem Licht.

Mit dem Bezugszeichen 9 ist das Kunststoffgehäuse bezeichnet, in dem eine Trägerplatte 6 als Teil eines Reflektors 5 mit den beiden LED-Chips 3, 4 eingegossen ist. Der Reflektor 5 ist zugleich als gemeinsamer Anschlusskontakt 7, 70 ausgebildet und als mittlerer Anschlusskontakt aus dem Gehäuse 9 herausgeführt. Der mittlere Anschlusskontakt 70 ist zu beiden Seiten durch einen ersten und zweiten Anschlusskontakt 71, 72 umgeben, die zur elektrischen Verbindung mit den beiden LED-Chips 3, 4 vorgehen sind. Die beiden Anschlusskontakte 71, 72 bilden im Bereich der Trägerplatte 6 jeweils eine Kontaktierungsfläche zur Kontaktierung der beiden LED-Chips 3, 4 mit diesen über Bonddrähte 8 aus.

Mit AS ist die im vorliegenden Beispiel senkrecht zur Bildebene verlaufende Symmetrieachse bezeichnet. Jeweils orthogonal zu dieser und miteinander gleichfalls orthogonal sind eine Hochachse HA und eine Querachse QA eingetragen.

Gemäss der Erfindung sind beide LED-Chips 3, 4 nebeneinander angeordnet. Das Verhältnis der optisch aktiven Oberfläche des ersten LED-Chips 3 zu der optisch aktiven Oberfläche des zweiten LED-Chips 4 liegt in einem Bereich von 2 bis 20, insbesondere in einem Bereich von 2,5 bis 6,5 liegt. Im vorliegenden Beispiel liegt das Verhältnis bei etwa 2.77 =(0.5 x 0.5 mm)² / (0.3 x 0.3 mm)², wobei die Seitenlänge der beiden beispielhaft quadratischen LED-Chips 3, 4 eine Kantenlänge von 0.5 mm bzw. 0.3 mm aufweisen.

In der gezeigten FIG 2 verläuft die Symmetrieachse AS zwischen den beiden LED-Chips 3, 4. Dies ist nicht zwingend erforderlich. Sie kann auch durch den grösseren der beiden LED-Chips 3 verlaufen. Mit HAR und HAB sind die beiden Hauptstrahlrichtungen der beiden LED-Chips 3, 4 bezeichnet. Diese entsprechen in geometrischer Hinsicht der jeweiligen Flächennormalen der als Flächenstrahler ausgebildeten LED-Chips 3, 4. Beide Hauptabstrahlrichtungen HAR, HAB verlaufen in diesem Beispiel parallel zueinander und auch parallel zur Symmetrieachse AS.

FIG 2 zeigt eine Aufsicht auf die beispielhafte Leuchtdiode 1 aus FIG 1 mit zwei integrierten und unterschiedlich grossen LED-Chips 3, 4 zum Aussenden von (nur) zweifarbigem Licht, d.h. entsprechend der Stromansteuerung der Leuchtdiode 1 zum Aussenden von einfarbigem blauem oder rotem Licht, oder von zweifarbigen blauem und roten Licht.

FIG 3 zeigt die Leuchtdiode 1 aus FIG 1 mit einer vorgeschalteten alternativen Blendeneinrichtung 12, 13. In dieser Ausführungsform ist die Blendeneinrichtung 12, 13 derart angeordnet und ausgerichtet, dass die von den beiden LED-Chips 3, 4 ausgesandten Lichtbündel BL, RO im Wesentlichen vollständig durch die Blendenöffnung OF hindurchtreten.

Anstelle der Lochblende 12 als Blendeneinrichtung 12, 13 kann alternativ zur Lochblende 12 auch ein Steg 13 als Blende für die Leuchtdiode 1 verwendet werden. Der Einfachheit halber sind beide Varianten gemeinsam in der FIG 3 eingezeichnet.

Gemäss der Erfindung ist eine durch die Symmetrie- und Querachse AS, QA verlaufende Lichtebene LE festgelegt. Es ist durch die optische Linse 14 oder durch die optische Linseneinheit ein auf der Symmetrieachse AS liegender Fokuspunkt F bzw. Fokus optisch festgelegt. Mit dem Fokuspunkt F als Scheitelpunkt ist ein Abstrahlwinkel α definiert, der sich ausgehend von der Symmetrieachse AS innerhalb der Lichtebene LE erstreckt. Es ist ein erster Abblendwinkelwert A_{b} und ein zweiter Abblendwinkelwert Wert Aᵣ für den Abstrahlwinkel α durch zwei sich gegenüberliegende, die Blendenöffnung OF begrenzende Innenränder der Blendeneinrichtung 12, 13 bestimmt. Die Blendeneinrichtung 12, 13 ist derart ausgerichtet und bemessen, dass die Abblendwinkelwerte A_{b}, Aᵣ unterschiedlich gross sind. Insbesondere unterscheiden sie sich betragsmässig um den Faktor zwei bis sechs. Durch diese asymmetrische Bestrahlung des Streulichtzentrums SZ ist eine Bevorzugung des wirkungsgradmässig schlechten "blauen" Lichts möglich.

FIG 4 zeigt die Leuchtdiode 1 aus FIG 1 mit einer vorgeschalteten weiteren alternativen Blendeneinrichtung 12, 13.

Gemäss dieser Ausführungsform ist die Blendeneinrichtung 12, 13 derart angeordnet und ausgerichtet, dass das vom ersten LED-Chip 3 ausgesandte blaue Lichtbündel BL und das vom zweiten LED-Chip 4 ausgesandte rote Lichtbündel RO nur teilweise, insbesondere weniger als 75%, durch die Blendenöffnung OF hindurchtritt. Im vorliegenden Beispiel tritt in etwa nur die Hälfte des jeweiligen abgestrahlten Lichts durch die Blendenöffnung OF hindurch.

FIG 5 zeigt ein Beispiel für die spezifische spektrale Empfindlichkeit S_{Rel} einer Silizium-PIN-Photodiode 2 mit erhöhter Blauempfindlichkeit. Über der Abszisse ist die Lichtwellenlänge λ des detektierten Lichts in Nanometer aufgetragen, über der Ordinate die spezifische spektrale Empfindlichkeit S_{Rel} am Beispiel einer Silizium-PIN-Photodiode vom Typ BPW34B der Fa. OSRAM in Prozentwerten. Die spektrale Empfindlichkeit S_{Rel} ist mit einem 100 %-Wert auf die spektral empfindlichste Lichtwellenlänge bei 850 nm normiert.

Wie das Diagramm zeigt, ist die spektrale "blaue" Empfindlichkeit SB des Photosensors 2 für blaues Licht mit einem Wellenlängenwert Λ1 von 470 nm mit 52 % in etwa 1.7 mal schlechter als die spektrale "rote" Empfindlichkeit SR des Photosensors 2 für infrarotes Licht bei einem Wellenlängenwert Λ2 von 940 nm mit 90 %.

### Bezugszeichenliste

- 1: LED, Leuchtdiode
- 2: Photosensor, Halbleiter-Photodiode, Silizium-PIN-Photodiode
- 3, 4: LED-Chip, Flächenstrahler
- 5: Reflektor, Reflektorring
- 6: Träger, Trägerplatte
- 7: Anschlusskontakte
- 8: Bonddrähte
- 9: Gehäuse, Kunststoffgehäuse
- 10: Detektionseinheit
- 11: Lamelle, Lichtabschirmelement
- 12: Blendeneinrichtung, Lochblende
- 13: Blendeneinrichtung, Steg
- 14: optische Linse
- 15: Empfängerlinse
- 16: Empfängerabblendeinrichtung, Lochblende
- 70: gemeinsamer Anschlusskontakt
- 71: erster Anschlusskontakt
- 71, 72: Kontaktierungsflächen
- 72: zweiter Anschlusskontakt

- AE: optische Achse des Empfängers
- AS: Symmetrieachse der LED, Hauptlängsachse
- BL: Lichtbündel, "blaues" Lichtbündel
- BZ: ("blaues") Streulichtzentrum
- F: Fokuspunkt, Fokus
- HA: Hochachse
- HAB: ("blaue") Hauptabstrahlrichtung
- HAR: ("rote") Hauptabstrahlrichtung
- LE: Lichtebene
- MZ: Mittleres Streulichtzentrum
- OF: Blendenöffnung
- QA: Querachse
- RO: Lichtbündel, "rotes" Lichtbündel
- RZ: ("rotes") Streulichtzentrum
- SB: ("blaue") spektrale Empfindlichkeit
- SR: ("rote") spektrale Empfindlichkeit
- SZ: Streulichtzentrum
- S_{Rel}: relative spektrale Empfindlichkeit
- α: Abstrahlwinkel
- A_{b}: ("blauer") Abblendwinkelwert
- Aᵣ: ("roter") Abblendwinkelwert
- β: Abschirmwinkel
- δ: Streulichtwinkel
- λ: Lichtwellenlänge
- Λ1: erster Wellenlängenwert
- Λ2: zweiter Wellenlängenwert

## Patentansprüche

1. Optischer Rauchmelder mit einer nach dem Streulichtprinzip arbeitenden Detektionseinheit (10), welche eine Leuchtdiode (1) zum Bestrahlen von zu detektierenden Partikeln und einen dafür spektral empfindlichen Photosensor (2) zur Detektion des von den Partikeln gestreuten Lichts aufweist,
- wobei die Leuchtdiode (1) einen ersten als Flächenstrahler ausgebildeten LED-Chip (3) zum Aussenden eines ersten Lichtbündels (BL) mit Licht in einem ersten Wellenlängenbereich von 350 nm bis 500 nm aufweist,
- wobei die Leuchtdiode (1) einen zweiten als Flächenstrahler ausgebildeten LED-Chip (4) zum Aussenden eines zweiten Lichtbündels (RO) mit Licht in einem zweiten Wellenlängenbereich von 665 nm bis 1000 nm aufweist,
- wobei die beiden LED-Chips (3, 4) nebeneinander angeordnet sind, und
- **dadurch gekennzeichnet dass**, das Verhältnis der optisch aktiven Oberfläche des ersten LED-Chips (3) zu der optisch aktiven Oberfläche des zweiten LED-Chips (4) in einem Bereich von 2 bis 20 liegt.

2. Optischer Rauchmelder nach Anspruch 1, wobei das Verhältnis der optisch aktiven Oberfläche des ersten LED-Chips (3) zu der optisch aktiven Oberfläche des zweiten LED-Chips (4) in einem Bereich von 2,5 bis 6,5 liegt.

3. Optischer Rauchmelder nach Anspruch 1 oder 2, wobei der erste LED-Chip (3) zum Aussenden von Licht mit einer Wellenlänge von 460 nm ± 40 nm oder 390 nm ± 40 nm und der zweite LED-Chip (4) zum Aussenden von Licht mit einer Wellenlänge von 940 nm ± 40 nm oder 860 nm ± 40 nm ausgebildet ist.

4. Optischer Rauchmelder nach einem der Ansprüche 1 bis 3, wobei die Leuchtdiode (1) eine Symmetrieachse (AS) aufweist und wobei eine jeweilige Hauptabstrahlrichtung (HAB, HAR) der beiden LED-Chips (3, 4) parallel zur Symmetrieachse (AS) ist.

5. Optischer Rauchmelder nach einem der Ansprüche 1 bis 3, wobei die Leuchtdiode (1) eine Symmetrieachse (AS) aufweist, wobei die beiden LED-Chips (3, 4) jeweils eine Hauptabstrahlrichtung (HAB, HAR) aufweisen und wobei zumindest eine der Hauptabstrahlrichtungen (HAB, HAR) zur Symmetrieachse (AS) geneigt ist.

6. Optischer Rauchmelder nach einem der Ansprüche 1 bis 5, wobei in der Detektionseinheit (10) eine Blendeneinrichtung (12, 13) mit einer Blendenöffnung (OF) zwischen der Leuchtdiode (1) und dem Photosensor (2) angeordnet ist, wobei die Blendeneinrichtung (12, 13) derart angeordnet und ausgerichtet ist, dass die von den beiden LED-Chips (3, 4) ausgesandten Lichtbündel (BL, RO) im Wesentlichen vollständig durch die Blendenöffnung (OF) hindurchtreten.

7. Optischer Rauchmelder nach einem der Ansprüche 1 bis 5, wobei in der Detektionseinheit (10) eine Blendeneinrichtung (12, 13) mit einer Blendenöffnung (OF) zwischen der Leuchtdiode (1) und dem Photosensor (2) angeordnet ist, wobei die Blendeneinrichtung (12, 13) derart angeordnet und ausgerichtet ist, dass weniger als 75% des vom ersten LED-Chip (3) ausgesandten ersten Lichtbündels (BL) und weniger als 75% des vom zweiten LED-Chip (4) ausgesandten zweiten Lichtbündels (RO) durch die Blendenöffnung (OF) hindurchtreten.

8. Optischer Rauchmelder nach einem der Ansprüche 1 bis 5, wobei in der Detektionseinheit (10) eine Blendeneinrichtung (12, 13) mit einer Blendenöffnung (OF) zwischen der Leuchtdiode (1) und dem Photosensor (2) angeordnet ist, wobei die Blendeneinrichtung (12, 13) derart angeordnet und ausgerichtet ist, dass das von einem der LED-Chips (3, 4) ausgesandte Lichtbündel (BL, RO) im Wesentlichen vollständig durch die Blendenöffnung (OF) hindurchtritt, während weniger als 75% des vom anderen LED-Chip (4, 3) ausgesandten Lichtbündels (RO, BL) durch die Blendenöffnung (OF) hindurchtritt.

9. Optischer Rauchmelder nach Anspruch 6, 7 oder 8, wobei die Leuchtdiode (1) eine Symmetrieachse (AS) aufweist und wobei die Leuchtdiode (1) derart um diese Symmetrieachse (AS) gedreht angeordnet ist, das vom zweiten LED-Chip (4) ausgesandte Licht im Vergleich zum ausgesandten Licht des ersten LED-Chips (3) mehr zum Photosensor (2) hin gerichtet ist.

10. Optischer Rauchmelder nach Anspruch 6, 7, 8 oder 9, wobei die Leuchtdiode (1) ein Gehäuse (9) aus einem insbesondere transparenten Kunststoff aufweist,
- wobei das Gehäuse (9) entlang des Bereichs nach dem Lichtaustritt aus den beiden LED-Chips (3, 4) eine optische Linse (14) ausbildet und/oder
- wobei zwischen der Leuchtdiode (1) und der Blendenöffnung (OF) eine optische Linseneinheit angeordnet ist.

11. Optischer Rauchmelder nach Anspruch 10, wobei die Leuchtdiode (1) eine senkrecht zur Symmetrieachse (AS) und durch die beiden nebeneinander angeordneten LED-Chips (3, 4) verlaufende Querachse (QA) aufweist, wobei eine durch die Symmetrie- und Querachse (AS, QA) verlaufende Lichtebene (LE) festgelegt ist, wobei durch die optische Linse (14) oder durch die optische Linseneinheit ein auf der Symmetrieachse (AS) liegenden Fokuspunkt (F) optisch festgelegt ist, wobei mit dem Fokuspunkt (F) als Scheitelpunkt ein Abstrahlwinkel (α) definiert ist, der sich ausgehend von der Symmetrieachse (AS) innerhalb der Lichtebene (LE) erstreckt, wobei ein erster Abblendwinkelwert (A_{b}) und ein zweiter Abblendwinkelwert Wert (Aᵣ) für den Abstrahlwinkel (α) durch zwei sich gegenüberliegende, die Blendenöffnung (OF) begrenzende Innenränder der Blendeneinrichtung (12, 13) bestimmt ist, und wobei die Blendeneinrichtung (12, 13) derart ausgerichtet und bemessen ist, dass die beiden Abblendwinkelwerte (A_{b}, Aᵣ) unterschiedlich gross sind.

12. Optischer Rauchmelder nach Anspruch 11, wobei die Blendeneinrichtung (12, 13) derart ausgerichtet und bemessen ist, dass die beiden Abblendwinkelwerte (A_{b}, Aᵣ) sich betragsmässig um den Faktor zwei bis sechs unterscheiden.

13. Optischer Rauchmelder nach einem der vorherigen Ansprüche, wobei der Rauchmelder eine mit der Leuchtdiode (1) und mit dem Photosensor (2) verbundene elektronische Steuereinheit aufweist, wobei die Steuereinheit dazu eingerichtet ist, eine Warnmeldung und/oder eine Alarmmeldung auszugeben, falls ein Mindestkonzentrationswert von Rauch detektierbar ist.

14. Optischer Rauchmelder nach Anspruch 13, wobei die Steuereinheit dazu eingerichtet ist, den ersten LED-Chip (3) mit seinem spezifizierten Nennstrom anzusteuern, und wobei die Steuereinheit weiterhin dazu eingerichtet ist, den zweiten LED-Chip (4) mit einem im Vergleich zu seinem spezifizierten Nennstrom festlegbaren Reduktionsfaktor anzusteuern.

15. Optischer Rauchmelder nach Anspruch 14, wobei der Reduktionsfaktor durch die unterschiedliche spektrale Empfindlichkeit (SR, SB) des Photosensors (2) für zu detektierendes gestreutes Licht im ersten und zweiten Wellenlängenbereich festgelegt ist.

16. Optischer Rauchmelder nach einem der vorherigen Ansprüche, wobei der Photosensor (2) eine Silizium-PIN-Photodiode ist.

17. Optischer Rauchmelder nach einem der vorherigen Ansprüche, wobei die beiden LED-Chips (3, 4) abwechselnd gepulst oder gleichzeitig gepulst durch die elektronische Steuereinheit ansteuerbar sind.

## Claims

1. Optical smoke alarm with a detector unit (10) that works according to the scattered light principle, which comprises a light-emitting diode (1) to irradiate particles to be detected and, for this, a spectrally sensitive photo sensor (2) to detect the light scattered by the particles,
- wherein the light-emitting diode (1) comprises a first LED chip (3) embodied as a surface emitter to emit a first light bundle (BL) with light in a first wavelength range of from 350 nm to 500 nm,
- wherein the light-emitting diode (1) comprises a second LED chip (4) embodied as a surface emitter to emit a second light bundle (RO) with light in a second wavelength range of from 665 nm to 1000 nm,
- wherein the two LED chips (3, 4) are arranged next to each other and
- **characterised in that** the ratio of the optically active surface of the first LED chip (3) to the optically active surface of the second LED chip (4) is within a range of from 2 to 20.

2. Optical smoke alarm according to claim 1, wherein the ratio of the optically active surface of the first LED chip (3) to the optically active surface of the second LED chip (4) is within a range of from 2.5 to 6.5.

3. Optical smoke alarm according to claim 1 or claim 2, wherein the first LED chip (3) is embodied to emit light with a wavelength of 460 nm ± 40 nm or 390 nm ± 40 nm, and the second LED chip (4) to emit light with a wavelength of 940 nm ± 40 nm or 860 nm ± 40 nm.

4. Optical smoke alarm according to one of claims 1 to 3, wherein the light-emitting diode (1) has an axis of symmetry (AS) and wherein a respective main direction of radiation (HAB, HAR) of the two LED chips (3, 4) is parallel toward the axis of symmetry (AS).

5. Optical smoke alarm according to one of claims 1 to 3, wherein the light-emitting diode (1) has an axis of symmetry (AS), wherein the two LED chips (3, 4) each have a main direction of radiation (HAB, HAR) and wherein at least one of the main directions of radiation (HAB, HAR) is inclined toward the axis of symmetry (AS).

6. Optical smoke alarm according to one of claims 1 to 5, wherein a diaphragm mechanism (12, 13) with a diaphragm aperture (OF) is arranged in the detector unit (10) between the light-emitting diode (1) and the photo sensor (2), wherein the diaphragm mechanism (12, 13) is arranged and aligned such that the light bundles (BL, RO) emitted by the two LED chips (3, 4) pass substantially completely through the diaphragm aperture (OF).

7. Optical smoke alarm according to one of claims 1 to 5, wherein a diaphragm mechanism (12, 13) with a diaphragm aperture (OF) is arranged in the detector unit (10) between the light-emitting diode (1) and the photo sensor (2), wherein the diaphragm mechanism (12, 13) is arranged and aligned such that less than 75% of the first light bundle (BL) emitted by the first LED chip (3) and less than 75% of the second light bundle (RO) emitted by the second LED chip (4) pass through the diaphragm aperture (OF).

8. Optical smoke alarm according to one of claims 1 to 5, wherein in the detector unit (10) a diaphragm mechanism (12, 13) with a diaphragm aperture (OF) is arranged between the light-emitting diode (1) and the photo sensor (2), wherein the diaphragm mechanism (12, 13) is arranged and aligned such that the light bundle (BL, RO) emitted by one of the LED chips (3, 4) passes substantially completely through the diaphragm aperture (OF), while less than 75% of the light bundle (RO, BL) emitted by the other LED chip (4, 3) passes through the diaphragm aperture (OF).

9. Optical smoke alarm according to claim 6, 7 or 8, wherein the light-emitting diode (1) has an axis of symmetry (AS) and wherein the light-emitting diode (1) is arranged rotated about this axis of symmetry (AS) such that light emitted by the second LED chip (4) is directed more toward the photo sensor (2) than the light emitted by the first LED chip (3).

10. Optical smoke alarm according to claim 6, 7, 8 or 9, wherein the light-emitting diode (1) comprises a housing (9) made of an in particular transparent plastic,
- wherein the housing (9) forms an optical lens (14) along the region after the light outlet from the two LED chips (3, 4) and/or
- wherein an optical lens unit is arranged between the light-emitting diode (1) and the diaphragm aperture (OF).

11. Optical smoke alarm according to claim 10, wherein the light-emitting diode (1) has a transverse axis (QA) extending perpendicular toward the axis of symmetry (AS) and through the two LED chips (3, 4) arranged next to each other, wherein a light plane (LE) extending through the axis of symmetry and transverse axis (AS, QA) is defined, wherein the optical lens (14) or the optical lens unit optically defines a focus point (F) lying on the axis of symmetry (AS), wherein, with the focus point (F) as the vertex, an angle of radiation (α) is defined that extends starting from the axis of symmetry (AS) within the light plane (LE), wherein a first dimming angle value (A_{b}) and a second dimming angle value (Aᵣ) is determined for the angle of radiation (α) by two opposing inside edges of the diaphragm mechanism (12, 13) bounding the diaphragm aperture (OF), and wherein the diaphragm mechanism (12, 13) is aligned and dimensioned such that the two dimming angle values (A_{b}, Aᵣ) are of different sizes.

12. Optical smoke alarm according to claim 11, wherein the diaphragm mechanism (12, 13) is aligned and dimensioned such that the two dimming angle values (A_{b}, Aᵣ) differ in size from each other by a factor of two to six.

13. Optical smoke alarm according to one of the preceding claims, wherein the smoke alarm comprises an electronic control unit connected to the light-emitting diode (1) and to the photo sensor (2), wherein the control unit is configured to output a warning and/or an alarm when a minimum concentration value of smoke can be detected.

14. Optical smoke alarm according to claim 13, wherein the control unit is configured to control the first LED chip (3) with its specified nominal current and wherein the control unit is also configured to control the second LED chip (4) with a reduction factor that can be defined in comparison with its specified nominal current.

15. Optical smoke alarm according to claim 14, wherein the reduction factor is defined by the different spectral sensitivity (SR, SB) of the photo sensor (2) for scattered light to be detected in the first and second wavelength range.

16. Optical smoke alarm according to one of the preceding claims, wherein the photo sensor (2) is a silicon PIN photodiode.

17. Optical smoke alarm according to one of the preceding claims, wherein the two LED chips (3, 4) can be controlled by the electronic control unit with alternate pulsing or simultaneous pulsing.

## Revendications

1. Détecteur de fumée optique avec une unité de détection (10) fonctionnant selon le principe de la lumière diffusée, laquelle comprend une diode électroluminescente (1) pour l'irradiation de particules à détecter et un photodétecteur (2) sensible à celles-ci d'un point de vue spectral pour la détection de la lumière diffusée par les particules,
- dans lequel la diode électroluminescente (1) comprend une première puce LED (3) conçue sous la forme d'un émetteur plan pour l'émission d'un premier faisceau de lumière (BL) avec de la lumière située dans une première plage de longueurs d'onde allant de 350 nm à 500 nm,
- dans lequel la diode électroluminescente (1) comprend une deuxième puce LED (4) conçue sous la forme d'un émetteur plan pour l'émission d'un deuxième faisceau de lumière (RO) avec de la lumière située dans une deuxième plage de longueurs d'onde allant de 665 nm à 1 000 nm,
- dans lequel les deux puces LED (3, 4) sont disposées l'une à côté de l'autre, et
- **caractérisé en ce que** le rapport de la surface optiquement active de la première puce LED (3) à la surface optiquement active de la deuxième puce LED (4) est compris dans une plage allant de 2 à 20.

2. Détecteur de fumée optique selon la revendication 1, dans lequel le rapport de la surface optiquement active de la première puce LED (3) à la surface optiquement active de la deuxième puce LED (4) est compris dans une plage allant de 2,5 à 6,5.

3. Détecteur de fumée optique selon la revendication 1 ou la revendication 2, dans lequel la première puce LED (3) est conçue pour l'émission de lumière avec une longueur d'onde de 460 nm ± 40 nm ou 390 nm ± 40 nm et la deuxième puce LED (4) est conçue pour l'émission de lumière avec une longueur d'onde de 940 nm ± 40 nm ou 860 nm ± 40 nm.

4. Détecteur de fumée optique selon l'une des revendications 1 à 3, dans lequel la diode électroluminescente (1) présente un axe de symétrie (AS) et dans lequel une direction de rayonnement principale respective (HAB, HAR) des deux puces LED (3, 4) est parallèle à l'axe de symétrie (AS).

5. Détecteur de fumée optique selon l'une des revendications 1 à 3, dans lequel la diode électroluminescente (1) présente un axe de symétrie (AS), dans lequel les deux puces LED (3, 4) présentent respectivement une direction de rayonnement principale (HAB, HAR) et dans lequel au moins l'une des directions de rayonnement principales (HAB, HAR) est inclinée par rapport à l'axe de symétrie (AS).

6. Détecteur de fumée optique selon l'une des revendications 1 à 5, dans lequel, dans l'unité de détection (10), un dispositif formant diaphragme (12, 13) avec une ouverture de diaphragme (OF) est disposé entre la diode électroluminescente (1) et le photodétecteur (2), dans lequel le dispositif formant diaphragme (12, 13) est disposé et dirigé de telle sorte que les faisceaux de lumière (BL, RO) émis par les deux puces LED (3, 4) passent essentiellement en totalité à travers l'ouverture de diaphragme (OF).

7. Détecteur de fumée optique selon l'une des revendications 1 à 5, dans lequel, dans l'unité de détection (10), un dispositif formant diaphragme (12, 13) avec une ouverture de diaphragme (OF) est disposé entre la diode électroluminescente (1) et le photodétecteur (2), dans lequel le dispositif formant diaphragme (12, 13) est disposé et dirigé de telle sorte que moins de 75 % du premier faisceau de lumière (BL) émis par la première puce LED (3) et moins de 75 % du deuxième faisceau de lumière (RO) émis par la deuxième puce LED (4) passent à travers l'ouverture de diaphragme (OF).

8. Détecteur de fumée optique selon l'une des revendications 1 à 5, dans lequel, dans l'unité de détection (10), un dispositif formant diaphragme (12, 13) avec une ouverture de diaphragme (OF) est disposé entre la diode électroluminescente (1) et le photodétecteur (2), dans lequel le dispositif formant diaphragme (12, 13) est disposé et dirigé de telle sorte que le faisceau de lumière (BL, RO) émis par l'une des puces LED (3, 4) passe essentiellement en totalité à travers l'ouverture de diaphragme (OF), tandis que moins de 75 % du faisceau de lumière (RO, BL) émis par l'autre puce LED (4, 3) passe à travers l'ouverture de diaphragme (OF).

9. Détecteur de fumée optique selon la revendication 6, la revendication 7 ou la revendication 8, dans lequel la diode électroluminescente (1) présente un axe de symétrie (AS) et dans lequel la diode électroluminescente (1) est disposée rotative autour de cet axe de symétrie (AS) de telle sorte que la lumière émise par la deuxième puce LED (4) soit dirigée davantage vers le photodétecteur (2) en comparaison avec la lumière émise de la première puce LED (3).

10. Détecteur de fumée optique selon la revendication 6, la revendication 7, la revendication 8 ou la revendication 9, dans lequel la diode électroluminescente (1) comprend un boîtier (9) en matière plastique particulièrement transparente,
- dans lequel le boîtier (9) constitue une lentille optique (14) le long de la zone après la sortie de lumière des deux puces LED (3, 4) et/ou
- dans lequel une unité à lentille optique est disposée entre la diode électroluminescente (1) et l'ouverture de diaphragme (OF).

11. Détecteur de fumée optique selon la revendication 10, dans lequel la diode électroluminescente (1) présente un axe transversal (QA) s'étendant perpendiculairement à l'axe de symétrie (AS) et de part et d'autre des deux puces LED (3, 4) disposées l'une à côté de l'autre, dans lequel un plan lumineux (LE) s'étendant de part et d'autre de l'axe de symétrie et transversal (AS, QA) est fixé, dans lequel un point focal (F) se situant sur l'axe de symétrie (AS) est optiquement fixé par la lentille optique (14) ou par l'unité à lentille optique, dans lequel il est défini avec le point focal (F) en tant que sommet un angle de rayonnement (α) qui s'étend à partir de l'axe de symétrie (AS) à l'intérieur du plan lumineux (LE), dans lequel il est déterminé une première valeur d'angle d'obturation (A_{b}) et une deuxième valeur d'angle d'obturation (Aᵣ) pour l'angle de rayonnement (α) par deux bords intérieurs du dispositif formant diaphragme (12, 13) se faisant face et délimitant l'ouverture de diaphragme (OF), et dans lequel le dispositif formant diaphragme (12, 13) est dirigé et dimensionné de telle sorte que les deux valeurs d'angle d'obturation (A_{b}, Aᵣ) soient de grandeur différente.

12. Détecteur de fumée optique selon la revendication 11, dans lequel le dispositif formant diaphragme (12, 13) est dirigé et dimensionné de telle sorte que les deux valeurs d'angle d'obturation (A_{b}, Aᵣ) diffèrent du point de vue de l'amplitude d'un facteur allant de deux à six.

13. Détecteur de fumée optique selon l'une des revendications précédentes, dans lequel le détecteur de fumée comprend une unité de commande électronique reliée à la diode électroluminescente (1) et au photodétecteur (2), dans lequel l'unité de commande est conçue de sorte à émettre un message d'avertissement et/ou un message d'alarme au cas où une valeur de concentration minimale de fumée est détectable.

14. Détecteur de fumée optique selon la revendication 13, dans lequel l'unité de commande est conçue de sorte à actionner la première puce LED (3) avec son courant nominal spécifié, et dans lequel l'unité de commande est en outre conçue de sorte à actionner la deuxième puce LED (4) avec un facteur de réduction fixable en comparaison avec son courant nominal spécifié.

15. Détecteur de fumée optique selon la revendication 14, dans lequel le facteur de réduction est fixé par la sensibilité spectrale différente (SR, SB) du photodétecteur (2) à de la lumière diffusée à détecter dans la première et la deuxième plage de longueurs d'onde.

16. Détecteur de fumée optique selon l'une des revendications précédentes, dans lequel le photodétecteur (2) est une photodiode silicium-PIN.

17. Détecteur de fumée optique selon l'une des revendications précédentes, dans lequel les deux puces LED (3, 4) sont actionnables pulsées en alternance ou pulsées simultanément par l'unité de commande électronique.
